# EUROPEAN PATENT SPECIFICATION

(11) **EP 0 523 892 B1**
(45) Date of publication and mention of the grant of the patent: **28.12.1994**
(21) Application number: 92306177.4
(22) Date of filing: 03.07.1992
(51) Int. Cl.: C11D 7/50, C23G 5/032

(54) **Cleaning compositions**
Reinigungsmittel
Compositions de nettoyage

(30) Priority: 18.07.1991 GB 9115513
(43) Date of publication of application: 20.01.1993
(73) Proprietor: THE BRITISH PETROLEUM COMPANY P.L.C., London EC2M 7BA (GB)
(72) Inventor: Jeffrey, Gareth Charles, The British Petroleum, Sunbury-on-Thames, Middlesex, TW16 7LN (GB); Mihalik, Peter Frank, The British Petroleum, Sunbury-on-Thames, Middlesex, TW16 7LN (GB)
(74) Representative: Krishnan, Suryanarayana Kalyana

(56) References cited:
- EP-A- 0 330 379
- FR-A- 2 571 279
- US-A- 3 839 234

## Description

The present invention relates to cleaning compositions comprising blends of solvents suitable for cleaning electronic components.

It is well known to use various solvents and solvent blends as a cleaning agent for the removal of oil and other contaminants from substrates such as drill cuttings, beaches and clothing. Most of these solvents cannot be used for the removal of inorganic/organic fluxes or other contaminants encountered on electronic circuit boards and printed circuit boards. Removal of flux from such circuit boards is not only necessary for cosmetic reasons but also to prevent corrosion by such fluxes on the boards and prevent automatic testing of such boards. Hitherto the solvents primarily used for cleaning of electronic boards and components have been halogenated hydrocarbons such as the chlorofluorocarbons, the so called CFC's (Lea, C., "Restrictions on the Use of Chlorofluorocarbons for Cleaning Soldered PCB's, Circuit World, Vol 14, No. 4, pp 4-12 (1988))". Due to increasing restrictions on the production of CFC's, there has been a need to develop alternative cleaners which are environmentally more acceptable. Moreover, the presence of chlorine in these solvents have made them less acceptable, especially with a view to protecting the environment. The same is true of the use of such halogenated solvents for general degreasing and cleaning of metal, polymer, ceramic or glass substrates.

Several alternatives to CFC cleaners are already known. These are based on isopropyl alcohol or limonene which have been used in aqueous or semi-aqueous systems. Such systems have the disadvantage that they give rise to large volumes of effluent water. Isopropanol (hereafter "IPA") based cleaners also have to contend with the flammability of the solvent. Limonene based cleaners have a low flash point (< 50°C).

Use of formulations containing glycol ethers has been suggested as cleaning agents instead of CFC's. One such formulation is described in our published EP-A-330379 which describes the use of the middle phase derived from a mixture of one or more glycol ethers, a hydrocarbon and water for cleaning primarily oily contaminants on a substrate surface including inter alia electronic components. Similarly, US-A-3839234 describes a formulation comprising glycol ethers, glycols, alcohols, ammonia, amines and a liquid synthetic detergent for cleaning grease and oil from contaminated substrate surfaces. Neither of these, however, make any mention of compositions directed specifically to cleaning contaminants such as solders or fluxes on electronic substrates.

It has now been found that a selective blend of glycol ethers is particularly suitable for removing fluxes and ionic contaminants from electronic substrates and mitigates the problems of excessive effluent water, high flammability and low flash point.

Accordingly, the present invention is a cleaning composition for cleaning contaminated electronic substrates said composition comprising a blend of 2-30% w/w of ethoxyethoxy ethanol with at least one other glycol ether derivative selected from butoxyethoxy ethanol, methoxypropoxy propanol, ethoxypropoxy propanol and C₁-C₄ monocarboxylic acid esters thereof.

By the expression "contaminated electronic substrates" is meant here and throughout the specification that the substrate is a circuit board such as an electronic circuit board or a printed circuit board; electronic components whether based on glass, ceramics, metal, polymer or wood; semi-conductor devices; fibre optic cables; precision engineering components and the like contaminated with fluxes and/or ionic contaminants whether or not such boards have surface mounted technology (hereafter "SMT") components thereon. These circuit boards will hereafter be referred to as "CB" for convenience. Similarly ethoxyethoxy ethanol, butoxy ethoxy ethanol, methoxypropoxy propanol, and ethoxypropoxy propanol will hereafter be referred to as "EDGE", "BDGE", "MDP" and "EDP" respectively for convenience.

The cleaning composition of the present invention suitably comprises at least three glycol ethers, i.e. EDGE, BDGE and MDP and/or EDP. In such a composition, which has three glycol ethers, the amounts of each of the glycol ethers is suitably 10-20% EDGE, 70-90% w/w BDGE and 2-10% MDP or EDP. A more specific example of the cleaning composition is a blend of 15% EDGE, 80% BDGE and 5% MDP or EDP.

Where the monocarboxylic acid esters are used, these are suitably selected from the acetate and propionate esters, most preferably the acetate esters.

The cleaning compositions of the present invention have a flash point of above 85°C.

In use, the contaminated CB can be brought into contact with the composition for a few seconds by immersing the contaminated CB in a bath of the cleaning composition or by applying the composition on the contaminated CB by spraying or brush coating.

After application of the cleaning composition on to the electronic substrate, the cleaning composition on the contaminated CB may be agitated by, eg ultrasonic energy, by stirring or by brushing.

The cleaning composition is suitably applied on the substrate to be cleaned at ambient temperature but it would also be possible to gently warm the substrate being cleaned to a temperature up to 80°C.

After this operation, the cleaning composition can be removed from the treated substrate by rinsing with an appropriate fluid one or more times. The fluids that may be used to perform the rinsing operation are suitably the same blends that have been used as the cleaning composition. However, it would also be possible to rinse the cleaned substrate with water, an aqueous solution of a surfactant, isopropyl alcohol or a small amount of a HCFC, HFC or perfluoralkane.

After rinsing, the cleaned substrate is thoroughly dried before use. The present invention is further illustrated with reference to the following Examples and Comparative Tests:

### Examples and Comparative Tests

### General Procedure

Tests were undertaken in which copper foil rectangles (area per side = 12.5 cm²) were cleaned with dichloromethane and commercial solder applied (ERSIN (Registered Trade Mark) Multicore 60/40 5 core tin-lead solder with 362 flux applied by means of a hand held soldering iron, set to 250°C, ex Multicore Solders Ltd). The copper foils were then cleaned by immersing in blends of these solvents at 35°C for 1 minute. The treated foils were rinsed in fresh solvent, having the same composition as the cleaner and dried by means of blowing hot air across them. For comparison, similar soldered copper foil samples were cleaned by immersing in boiling trichlorotrifluorethane (CFC113)/methanol mixtures (composition 94/6 w/w) as detailed below.

The samples were examined for visual cleanliness and the amount of ionic contamination assessed by immersing in a 50/50 v/v mixture of isopropyl alcohol (IPA) deionised water for 15 minutes and monitoring the rise in conductivity. (The isopropanol/water mixture was purged with nitrogen before and during this test to eliminate conductivity rises due to carbon dioxide in the air absorbing into the mixture). As is conventionally done in the electronics industry, the rise in the conductivity of the IPA/water mixture was used to assess the equivalent amount of sodium chloride which, had this been leached from the surface of the substrate, would have given the same rise in conductivity of the IPA/water solution.

### Results:

### Comparative Tests

Cleaning composition (CFC113 94% by wt, methanol 6% wt)
Cleaning method: The copper foils were suspended in the vapour above the refluxing CFC/methanol mix for 5 seconds, immersed in boiling liquid for 1 minute, then suspended in vapour again for 30 seconds then finally allowed to dry in air.
Visual appearance: Clean with no stains or residue.
Residual ionic contamination: 0.25 micro g of NaCl equivalent /cm².

### Examples (Blends according to the Invention)

Blend 1: BDGE 80%, EDP 5%, EDGE 15% by weight.
   Cleaning method: Test foils were gently stirred in 100 g of cleaner at 35°C for 1 minute, rinsed in a fresh, similar solution for 5 seconds and blown dry with hot air.
   Cleanliness:
   Visual: Clean, with no stains or residue.
   Residual ionic contamination: 0.20 micro g of NaCl equivalent /cm².
Blend 2: Cleaning formulation 95% EDP, 5% EDGE by weight.
Blend 3: Cleaning formulation 85% BDGE, 15% EDGE by weight.
Blend 4: Cleaning composition 90% EDP, 5% BDGE, 5% EDGE by weight.

### (Same method as for Blend 1)

These systems gave the following:
Blend 2: Visually clean, no stains or residue, 0.24 micro g NaCl/cm² equivalent.
Blend 3: Visual assessment: Very slight stains remain, 0.18 micro g/cm² NaCl equivalent.
Blend 4: Visually clean, no stains or residue, 0.23 micro g/cm² NaCl equivalent.

### Comparative Tests

By comparison, similar tests with the individual solvents when used alone gave the following results:
(a) BDGE alone: Slight stains remain, 0.22 micro g/cm² equivalent.
(b) EDP alone: Slight residue, 0.27 micro g/cm² NaCl equivalent.
(c) EDGE alone: Slight residue remains, 0.14 micro g/cm² NaCl equivalent.
These Comparative Tests show that blends of EDGE/BDGE/EDP are more effective than the individual glycol ethers when used alone.

### Examples with Populated Boards

Electronic circuit boards, 225 cm², onto which had been fixed through hole components on one side of the board, and various surface mount technology (SMT) components on the other side of the board, were cleaned by immersing for 1 minute in a blend of butoxyethanol (90% by weight) and EDGE (10% by weight), rinsed in the same solvent blend, blown dry, and then placed in a Alpha Metals model 500M ionograph, filled with 75/25 (v/v) isopropanol/water mixture until no more ionic contamination leached from these boards. These cleaned boards, having thus been cleaned to similar conditions, were then coated with solder fluxes as follows:
2 g of Multicore type 362 or 366 flux (ex Multicore Solders Ltd) were dissolved in 3 g of isopropanol (IPA) and were spread evenly onto one side of the populated boards (the side covered with surface mount technology components). The side of the board which was covered with flux was then briefly touched onto the surface of a bath of molten 60/40 tin/lead solder (ex Multicore Solders Ltd) heated to 250°C. In an alternative method of applying flux to these test substrates, Multicore type RM92 solder paste was applied sparingly to component legs on the SMT side of the board. This was heated with a soldering iron set to 300°C.

The boards were cleaned by the following general method:
The boards were gently stirred in the solvent blend (3.5 litres) at the appropriate temperature and time (see below), rinsed in 2 litres of fresh solvent for 10 seconds, and blown dry with hot air.

### Comparative Tests:

For comparison, boards prepared similarly were cleaned in boiling CFC113/methanol (94/6 w/w) mixtures as follows:

The boards were gently stirred in boiling solvent (3.5 litres) for 1 minute rinsed in 2 litres of fresh boiling CF113/methanol mix for 30 seconds and left to dry in air.

The cleanliness of the boards was assessed visually, and by monitoring the residual ionic contamination by means of a Alpha Metals 500M ionograph. The results were as follows:
(d) 362 Flux
   Boards cleaned in CFC113/methanol mixture Visual appearance after cleaning: Clean, no stains or residue. Residual ionic contamination: 1.34 micro g NaCl equivalent/cm².
(e) 366 Flux
   Boards cleaned in CFC113/methanol mixture Visual appearance after cleaning: Clean, no stains or residue. Residual ionic contamination: 1.7 micro g NaCl equivalent/cm².
(f) RM92 Solder Paste
   Boards cleaned in CFC113/methanol mixture Visual appearance after cleaning: Clean, no stains or residue. Residue ionic contamination: 1.92 micro g NaCl equivalent/cm².

### Examples:

Blend 5: Boards cleaned in EDGE (15%)/BDGE (80%)/EDP (5%) mixtures:
(i) Boards covered with 362 flux, and cleaned at 45°C for 90 seconds.
   Visual appearance: Clean, no stains or residue.
   Residual ionic contamination: 0.51 micro g NaCl equivalent/cm².
(ii) Boards covered with 366 flux, cleaned at 45°C for 90 seconds.
   Visual appearance: Clean, no stains or residue.
   Residual ionic contamination: 0.81 micro g NaCl equivalent/cm².
(iii) Boards contaminated with RM92 paste, cleaned at 55°C for 75 seconds.
   Visual appearance: Clean, no stains or residue.
   Residual ionic contamination: 0.71 micro g/cm².

Blend 6: Boards cleaned in EDGE (5%) EDP (95%) mixtures:
(iv) Boards covered with 362 flux, and cleaned at 45°C for 90 seconds.
   Visual appearance: Clean, no residues or stains.
   Residual ionic contamination: 1.10 micro g NaCl equivalent/cm².
(v) Boards covered with 366 flux, cleaned at 45°C for 90 seconds.
   Visual appearance: Clean, no stains or residue.
   Residual ionic contamination: 0.91 micro g NaCl equivalent/cm².
(vi) Boards contaminated with RM92 paste, cleaned at 55°C for 75 seconds.
   Visual appearance: Clean, no stains or residue.
   Residue ionic contamination: 0.15 micro g/cm².

### Comparative Test

Board cleaned in BDGE (100%).
Board covered with 366 flux, and cleaned at 45°C for 90 seconds.
Visual appearance: Slight stains and residue on SMT.
Residual ionic contamination: 1.04 mg NaCl equivalent/cm².

### Examples (Blends according to the Invention):

Blend 6: BDGE 80%, MDP 5%, EDGE 15% by weight.

The circuit board used was a single-sided FR4 (a fire hazard standard) with surface mounted devices only. This board was initially cleaned with a 75%/25% mixture of isopropyl alcohol and water. On the cleaned board a flux of Multicore 6831/35 was applied by immersion. The soldering was carried out on this board at 250°C for 30 seconds. The fluxed and soldered board thus generated was not cleaned and had a contamination of 40.42 micro g of NaCl equivalent/cm². The board was then cleaned with the aforementioned Blend 6 of solvents as previously for a 3 minute wash at 30°C under the influence of ultrasonics and then rinsed for 30 seconds using the same solvent at 22°C but without the influence of ultrasonics. The resultant cleaned board had a clean appearance on visual examination and had a contamination level of only 0.4 micro g of NaCl equivalent/cm².

These results demonstrate that the new cleansing formulations are effective cleaners for electronic substrates.

## Claims

1. A cleaning composition for cleaning contaminated electronic substrates said composition comprising a blend of 2-30% w/w of ethoxyethoxy ethanol with at least one other glycol ether derivative selected from butoxyethoxy ethanol, methoxypropoxy propanol, ethoxypropoxy propanol and C₁-C₅ monocarboxylic acid esters thereof.

2. A cleaning composition according to Claim 1 wherein said composition comprises a blend of (a) ethoxyethoxy ethanol and butoxy ethoxy ethanol with (b) methoxypropoxy propanol and/or ethoxypropoxy propanol.

3. A cleaning composition according to Claim 2 wherein said composition comprises a blend of 10-20% w/w of ethoxyethoxy ethanol, 70-90% w/w of butoxyethoxy ethanol and 2-10% w/w of methoxypropoxy propanol or ethoxypropoxy propanol.

4. A cleaning composition according to Claim 1 wherein the monocarboxylic acid esters used are acetate and/or propinnate esters.

5. A cleaning composition according to any one of the preceding Claims wherein said composition has a flash point above 85°C.

6. A process for cleaning contaminated electronic substrates said process comprising bringing the contaminated electronic substrate into contact with a composition as claimed in Claim 1 and agitating the composition by ultrasonic energy, by stirring or by brushing.

7. A process according to Claim 6 wherein any of the cleaning composition adherent to the cleaned substrate is removed therefrom by rinsing the cleaned substrate one or more times with an appropriate fluid capable of dissolving the cleaning compositions.

8. A process according to Claim 7 wherein the appropriate fluid is selected from water, an aqueous solution of a surfactant, isopropyl alcohol and small amounts of hydrogenated chlorofluorocarbons, hydrogenated fluorocarbons and perfluoroalkanes.

## Patentansprüche

1. Reinigungszusammensetzung zur Reinigung verunreinigter elektronischer Substrate, die eine Mischung von 2-30% g/g Ethoxyethoxyethanol mit mindestens einem weiteren Glykoletherderivat, ausgewählt aus Butoxyethoxyethanol, Methoxypropoxypropanol, Ethoxypropoxypropanol und C₁-C₅-Monocarbonsäureestern derselben, umfaßt.

2. Reinigungszusammensetzung nach Anspruch 1, wobei die Zusammensetzung eine Mischung von (a) Ethoxyethoxyethanol und Butoxyethoxyethanol mit (b) Methoxypropoxypropanol und/oder Ethoxypropoxypropanol umfaßt.

3. Reinigungszusammensetzung nach Anspruch 2, wobei die Zusammensetzung eine Mischung von 10-20% g/g Ethoxyethoxyethanol, 70-90% g/g Butoxyethoxyethanol und 2-10% g/g Methoxypropoxypropanol oder Ethoxypropoxypropanol umfaßt.

4. Reinigungszusammensetzung nach Anspruch 1, wobei die verwendeten Monocarbonsäureester aus den Acetat- und/oder Propionat-Estern bestehen.

5. Reinigungszusammensetzung nach einem der vorhergehenden Ansprüche, wobei die Zusammensetzung einen Flammpunkt oberhalb 85°C aufweist.

6. Verfahren zur Reinigung von verunreinigten elektronischen Substraten, umfassend ein Inberührungbringen des verunreinigten elektronischen Substrats mit einer Zusammensetzung nach Anspruch 1 und Bewegen der Zusammensetzung durch Ultraschallenergie, durch Rühren oder durch Bürsten.

7. Verfahren nach Anspruch 6, wobei jegliche an dem gereinigten Substrat haftende Reinigungszusammensetzung davon durch ein- oder mehrmaliges Spülen des gereinigten Substrats mit einer geeigneten Flüssigkeit mit der Fähigkeit zur Auflösung der Reinigungszusammensetzungen entfernt wird.

8. Verfahren nach Anspruch 7, wobei die geeignete Flüssigkeit aus Wasser, einer wäßrigen Lösung eines Netzmittels, Isopropanol und geringen Mengen hydrierter Chlorfluorkohlenwasserstoffe, hydrierter Fluorkohlenwasserstoffe und Perfluoralkane ausgewählt ist.

## Revendications

1. Composition de nettoyage pour le nettoyage de substrats électroniques contaminés, ladite composition comprenant un mélange de 2 à 30 % en poids d'éthoxyéthoxyéthanol avec au moins un autre dérivé d'éther de glycol choisi entre le butoxyéthoxyéthanol, le méthoxypropoxypropanol, l'éthoxypropoxypropanol et leurs esters d'acides monocarboxyliques en C₁ à C₅.

2. Composition de nettoyage suivant la revendication 1, ladite composition comprenant un mélange (a) d'éthoxyéthoxyéthanol et de butoxyéthoxyéthanol avec (b) du méthoxypropoxypropanol et/ou de l'éthoxypropoxypropanol.

3. Composition de nettoyage suivant la revendication 2, ladite composition comprenant un mélange de 10 à 20 % en poids/poids d'éthoxyéthoxyéthanol, 70 à 90 % en poids/poids de butoxyéthoxyéthanol et 2 à 10 % en poids/poids de méthoxypropoxypropanol ou d'éthoxypropoxypropanol.

4. Composition de nettoyage suivant la revendication 1, dans laquelle les esters d'acides monocarboxyliques utilisés sont des esters acétiques et/ou propioniques.

5. Composition de nettoyage suivant l'une quelconque des revendications précédentes, ladite composition ayant un point d'éclair supérieur à 85°C.

6. Procédé de nettoyage de substrats électroniques contaminés, ledit procédé comprenant la mise en contact du substrat électronique contaminé avec une composition suivant la revendication 1 et l'agitation de la composition au moyen d'une énergie ultrasonique, par agitation mécanique ou par brossage.

7. Procédé suivant la revendication 6, dans lequel n'importe quelle quantité de la composition de nettoyage adhérant au substrat nettoyé est éliminée de ce substrat par rinçage du substrat nettoyé une fois ou plusieurs fois avec un fluide approprié capable de dissoudre les compositions de nettoyage.

8. Procédé suivant la revendication 7, dans lequel le fluide approprié est choisi entre l'eau, une solution aqueuse d'un surfactant, l'alcool isopropylique et de petites quantités de chlorofluorocarbones hydrogénés, de fluorocarbones hydrogénés et de perfluoralcanes.
